# FASCICULE DE BREVET EUROPEEN

(11) **EP 3 015 873 B1**
(45) Date de publication et mention de la délivrance du brevet: **29.11.2017**
(21) Numéro de dépôt: 15188656.1
(22) Date de dépôt: 06.10.2015
(51) Int. Cl.: G01R 22/06

(54) **PROCÉDÉ DE DÉTECTION D'UNE TENTATIVE DE BY-PASS FRAUDULEUX D'UN COMPTEUR**
DETEKTIONSVERFAHREN EINES BETRÜGERISCHEN BY-PASS-VERSUCHS AN EINEM ZÄHLER
METHOD FOR DETECTING A FRAUDULENT ATTEMPT TO BYPASS A METER

(30) Priorité: 31.10.2014 FR 1460520
(43) Date de publication de la demande: 04.05.2016
(73) Titulaire: SAGEMCOM ENERGY & TELECOM SAS, 92500 Rueil-Malmaison (FR)
(72) Inventeur: TEBOULLE, Henri, 92500 Rueil Malmaison (FR); BRETON, Thierry, 92500 Rueil Malmaison (FR); HERGAULT, Stéphane, 92500 Rueil Malmaison (FR); GEHENIAU, Frédéric, 92500 Rueil Malmaison (FR)
(74) Mandataire: Lavialle, Bruno François Stéphane

(56) Documents cités:
- WO-A1-2006/028856
- WO-A2-2009/156656
- FR-A1- 2 748 326
- FR-A1- 2 947 055
- FR-A1- 2 996 310
- US-A1- 2009 261 805

## Description

L'invention concerne un procédé de détection d'une tentative de by-pass frauduleux d'un compteur d'énergie électrique.

### ARRIERE PLAN DE L'INVENTION

Un compteur d'énergie électrique d'une installation électrique comporte très classiquement un capteur de courant (shunt, transformateur, etc.) destiné à mesurer un courant de phase consommé par l'installation électrique et circulant sur un conducteur de phase.

Un organe de coupure externe principal est parfois monté sur le conducteur de phase en amont du compteur, c'est-à-dire entre le compteur et un réseau de distribution d'où provient l'énergie électrique.

Une méthode de fraude connue consiste à relier à l'extérieur du compteur un point du conducteur de phase situé en amont du compteur à un point du conducteur de phase situé en aval du compteur.

On forme de la sorte une branche de dérivation externe dans laquelle circule au moins une partie du courant consommé par l'installation électrique. Ce type de fraude est usuellement désigné par le terme « by-pass ».

Un utilisateur fraudeur peut donc ainsi constituer une installation électrique principale alimentée via le compteur et dont la consommation électrique est normalement mesurée par le compteur, et une installation électrique additionnelle connectée à la branche de dérivation et dont la consommation électrique n'est pas prise en compte par la mesure réalisée par le compteur. Le point du conducteur de phase de la branche de dérivation situé en amont du compteur peut notamment être situé en amont de l'organe de coupure externe principal, ce qui permet à l'utilisateur fraudeur d'alimenter l'installation électrique additionnelle même lorsque l'organe de coupure externe principal est ouvert.

Dans le cas d'un compteur moderne, le relevé de la consommation est effectué à distance et ne nécessite plus l'intervention sur le compteur d'un agent releveur de compteur. Il est donc fondamental pour le distributeur d'énergie électrique qu'une telle tentative de fraude puisse être détectée sans intervention sur le compteur.

Pour détecter une telle tentative de fraude, une première solution consiste à mesurer un courant de neutre circulant sur un conducteur de neutre, à comparer le courant de neutre et le courant de phase (ou la valeur efficace de la somme des trois courants de phase dans le cas d'un compteur triphasé), et à détecter une tentative de fraude lorsque le rapport entre le courant de phase et le courant de neutre est supérieur à un seuil prédéterminé, ou inférieur à un autre seuil prédéterminé. Cette première solution ne permet cependant pas de détecter une tentative de fraude lorsque l'utilisateur fraudeur différencie, d'une part, le retour de neutre de l'installation électrique additionnelle, qu'il connecte en amont du compteur, et, d'autre part, le retour de neutre de l'installation électrique principale, qu'il connecte au compteur en aval du compteur.

Une deuxième solution, notamment décrite dans le document FR 2 983 301, consiste à connecter dans le compteur un élément de transformation entre le conducteur de phase et le conducteur de neutre, à générer un premier signal de type courant porteur en ligne au niveau d'une entrée de l'élément de transformation, à acquérir et analyser un deuxième signal de type courant porteur en ligne au niveau d'une sortie de l'élément de transformation, et à détecter la présence d'une branche de dérivation externe en fonction du résultat de cette analyse. Cette deuxième solution est non seulement coûteuse et encombrante, mais elle est aussi incompatible avec des exigences particulièrement sévères de robustesse à des courants injectés qui peuvent être spécifiées pour certains compteurs. Ces exigences peuvent ainsi consister, pour tester un organe de coupure interne du compteur (ou « breaker ») destiné à sélectivement connecter et déconnecter l'installation électrique du réseau de distribution, à soumettre l'organe de coupure interne à des injections de courants pouvant atteindre 5000 ampères pendant 10 millisecondes.

WO 2006/028856 A1 divulgue la gestion des charges électriques dans un système électrique de puissance.

### OBJET DE L'INVENTION

L'invention a pour objet de détecter une fraude par by-pass d'un compteur d'énergie électrique de manière fiable, peu onéreuse et sans dégrader la robustesse du compteur, lorsque le by-pass est réalisé en reliant à un point du conducteur de phase situé en aval du compteur un point situé en amont d'un organe de coupure monté entre le compteur et un réseau de distribution de l'énergie électrique.

### RESUME DE L'INVENTION

En vue de la réalisation de ce but, on propose un procédé de détection d'une tentative de by-pass frauduleux d'un compteur destiné à mesurer un courant circulant sur un conducteur entre un réseau de distribution situé en amont du compteur et une installation électrique située en aval du compteur. Le compteur comprend un capteur de courant monté sur le conducteur et une unité d'alimentation du compteur connectée au conducteur en amont du capteur de courant, un premier organe de coupure étant monté sur le conducteur en amont du compteur. Selon l'invention, le procédé de détection comporte une étape de mesure au cours de laquelle on mesure un courant de test grâce au capteur de courant lorsque le premier organe de coupure est ouvert et une étape de détection au cours de laquelle on détecte une tentative de by-pass frauduleux en fonction du courant de test mesuré.

L'unité d'alimentation requiert pour son fonctionnement et pour celui du compteur un courant électrique qui provient du réseau de distribution lorsqu'un tel courant est disponible. Or, lorsque le premier organe de coupure est ouvert, un tel courant est disponible seulement si une tentative de by-pass frauduleux est effectuée qui permet au courant de circuler depuis l'amont du premier organe de coupure vers le compteur. Dans ce cas, le courant circule via le by-pass et le capteur de courant du compteur, ce qui permet, en mesurant le courant de test, de détecter la tentative de by-pass frauduleux.

Le procédé de détection de l'invention permet donc de détecter une tentative de by-pass frauduleux en mesurant le courant de test grâce au capteur de courant déjà intégré dans un compteur classique et utilisé pour mesurer le courant circulant sur le conducteur pour évaluer l'énergie électrique consommée par l'installation électrique. Ainsi, comme le procédé de détection de l'invention ne nécessite pas d'équiper le compteur de composants additionnels dédiés à la détection, la mise en oeuvre du procédé de détection est peu onéreuse et ne dégrade pas la robustesse du compteur.

Comme le procédé de détection ne consiste pas à comparer un courant circulant sur un conducteur de phase et un courant circulant sur un conducteur de neutre, le procédé de détection n'est pas sensible à une différenciation des retours de neutre par l'utilisateur fraudeur comme évoqué plus tôt en relation avec la solution de l'art antérieur.

### BREVE DESCRIPTION DES DESSINS

Il sera fait référence aux dessins annexés, parmi lesquels :
- la figure 1 représente un compteur d'énergie électrique monophasé dans lequel est mis en oeuvre le procédé de détection de l'invention ;
- la figure 2 représente un compteur d'énergie électrique triphasé dans lequel est mis en oeuvre le procédé de détection de l'invention.

### DESCRIPTION DETAILLEE DE L'INVENTION

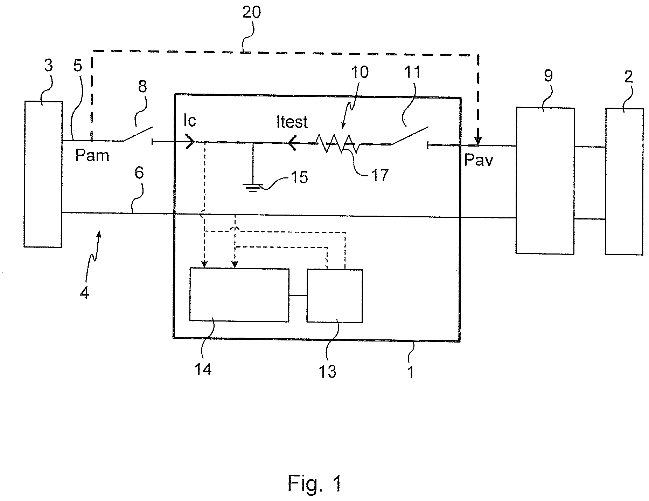

En référence à la figure 1, le procédé de détection de l'invention est tout d'abord mis en oeuvre dans un compteur d'énergie électrique monophasé 1 destiné à mesurer une énergie électrique qui est fournie par un réseau de distribution 3 situé en amont du compteur 1 et qui est consommée par une installation électrique 2 située en aval du compteur 1. L'installation électrique 2 n'est pas productrice de courant.

L'énergie électrique est transmise à l'installation électrique 2 par une ligne électrique 4 comprenant un conducteur de phase 5 et un conducteur de neutre 6 auxquels est raccordé le compteur 1.

Un organe de coupure externe principal, ou premier organe de coupure 8, est monté à l'extérieur du compteur 1 et en amont de celui-ci, entre le compteur 1 et le réseau de distribution 3. Le premier organe de coupure 8 peut être commandé pour couper la distribution d'énergie électrique à l'installation électrique 2 ainsi qu'éventuellement à d'autres installations électriques non représentées et elles aussi reliées au réseau de distribution 3.

Un disjoncteur 9 est en outre monté à l'extérieur du compteur 1 et en aval de celui-ci, entre le compteur 1 et l'installation électrique 2.

A l'intérieur du compteur 1 sont intégrés un capteur de courant 10, un organe de coupure interne ou deuxième organe de coupure 11, une unité de traitement 13 et une unité d'alimentation 14. Une masse électrique 15 du compteur 1 est reliée au conducteur de phase 5 à l'intérieur du compteur 1.

Le capteur de courant 10 est destiné à mesurer un courant consommé Ic circulant sur le conducteur de phase 5. Le capteur de courant 10 est monté sur le conducteur de phase 5 et comporte un shunt 17.

Le deuxième organe de coupure 11 est monté sur le conducteur de phase 5 en série avec le capteur de courant 10. Le deuxième organe de coupure 11 permet de sélectivement connecter et déconnecter, à distance, l'installation électrique 2 du réseau de distribution 3. Le deuxième organe de coupure 11 est utilisé pour protéger l'installation électrique 2 en s'ouvrant lorsqu'il est soumis à une surtension accidentelle provenant du réseau de distribution 3, et en se refermant, après disparition de cette surtension accidentelle, sur commande d'un opérateur du distributeur d'énergie électrique. Le deuxième organe de coupure 11 est aussi utilisé pour couper ou rétablir à distance l'alimentation de l'installation électrique 2 en cas par exemple de résiliation de l'abonnement de l'utilisateur de l'installation électrique 2 ou de non-paiement de l'énergie électrique consommée, sans qu'il soit nécessaire d'envoyer du personnel sur place.

L'unité de traitement 13 est connectée au conducteur de phase 5 et au conducteur de neutre 6 en amont du capteur de courant 10. L'unité de traitement 13 gère le fonctionnement du compteur 1 et, en particulier, transmet un certain nombre d'informations (relatives à la consommation, au fonctionnement du compteur, etc.) au distributeur d'énergie par courants porteurs en ligne circulant sur le conducteur de phase 5 en direction du réseau de distribution 3.

L'unité d'alimentation 14 est, elle aussi, connectée au conducteur de phase 5 et au conducteur de neutre 6 en amont du capteur de courant 10. L'unité d'alimentation 14 utilise le courant Ic provenant du réseau de distribution 3 pour alimenter les différents composants électriques du compteur 1 dont le fonctionnement requiert une alimentation électrique. On note que cette unité d'alimentation 14 est associée à une batterie (ou à une supercapacité) non représentée ici, qui permet d'alimenter les composants électriques du compteur 1 lorsque le premier organe de coupure 8 ou le deuxième organe de coupure 11 sont ouverts.

Le procédé de détection de l'invention est destiné à détecter un by-pass frauduleux qui est symbolisé sur la figure 1 par la ligne en pointillés représentant un court-circuit réalisé à l'aide d'un fil 20 reliée à deux points du conducteur 5 situés à l'extérieur du compteur 1, à savoir un point amont Pam situé en amont du compteur 1 et en amont du premier organe de coupure 8 et un point aval Pav situé en aval du compteur 1. Le procédé de détection de l'invention fonctionne avec un fil 20 présentant une longueur pouvant atteindre plusieurs mètres.

Le procédé de détection comprend les étapes de mesurer un courant de test Itest grâce au capteur de courant 10 lorsque le premier organe de coupure 8 est ouvert et lorsque le deuxième organe de coupure 11 est fermé et de détecter une tentative de by-pass frauduleux en fonction du courant de test Itest mesuré.

Lorsque le premier organe de coupure 8 est ouvert et que le fil 20 est installé comme cela a été précédemment décrit, le seul courant disponible pour fournir à l'unité d'alimentation 14 le courant nécessaire à son fonctionnement et à l'alimentation des composants électriques du compteur 1 circule depuis le réseau de distribution 3 via le fil 20 du by-pass, puis d'aval en amont depuis le point aval Pav du conducteur de phase 5. On rappelle en effet que l'installation électrique 2 n'est pas productrice de courant.

Ainsi, le procédé de détection de l'invention détecte une tentative de by-pass frauduleux lorsque le courant de test Itest mesuré présente un sens de circulation d'aval en amont vers l'unité d'alimentation 14 et sa valeur efficace est supérieure à un premier seuil de courant prédéterminé. On détecte de cette manière que l'unité d'alimentation 14 tire un courant provenant d'un point situé en aval de l'unité d'alimentation 14 et du capteur de courant 10.

Pour améliorer la détection de la tentative de fraude, on augmente artificiellement le courant consommé par le compteur 1 et donc par l'unité d'alimentation 14 lors de la mise en oeuvre du procédé de détection préalablement à la mesure du courant de test Itest.

Augmenter artificiellement le courant consommé par le compteur 1 et donc par l'unité d'alimentation 14 a pour conséquence d'augmenter la valeur du courant de test Itest lors d'une tentative de fraude, ce qui permet non seulement de mieux distinguer un cas de tentative de fraude d'un cas normal, mais aussi d'augmenter le temps au cours duquel la tentative de fraude peut être détectée. On améliore ainsi la détection en réduisant le taux de tentatives de fraude non détectées.

Pour cela, on commande la fermeture du deuxième organe de coupure 11 bien que, au moment de la mise en oeuvre du procédé de détection de l'invention, celui-ci soit déjà fermé. Cette confirmation de commande de fermeture du deuxième organe de coupure 11 permet d'augmenter la consommation électrique du compteur 1, typiquement d'environ 50mA.

On note ici que, grâce à la tentative de fraude, l'unité de traitement 13 peut envoyer des informations par courants porteurs en ligne au distributeur d'énergie via le fil 20 de by-pass. Cet envoi d'informations par courants porteurs en ligne est impossible lorsque le fil 20 n'est pas installé puisque le premier organe de coupure 8 est ouvert. Ainsi, le distributeur d'énergie qui reçoit des informations par courants porteurs en ligne provenant du compteur 1 alors que le premier organe de coupure 8 est ouvert est averti de la tentative de fraude.

On utilise donc les propres moyens du fraudeur pour avertir le distributeur d'énergie électrique qu'une tentative de fraude a lieu.

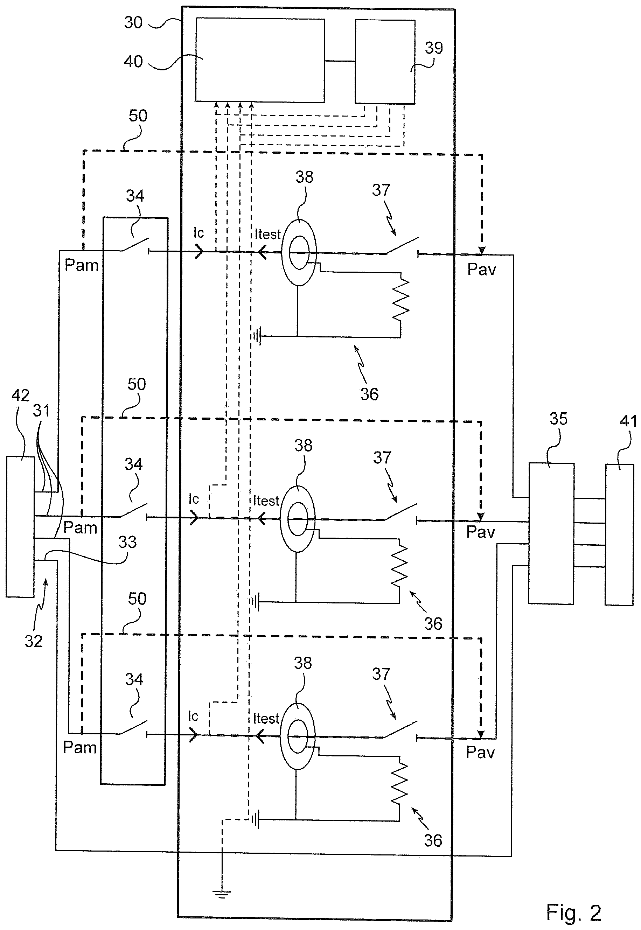

En référence à la figure 2, le procédé de détection de l'invention peut aussi être mis en oeuvre dans un compteur triphasé 30. Le compteur triphasé 30 est destiné à mesurer trois courants Ic circulant sur trois conducteurs de phase 31 d'une ligne électrique 32 qui, outre les trois conducteurs de phase 31, comporte un conducteur de neutre 33.

Trois organes de coupure externes, ou premiers organes de coupure 34, sont montés à l'extérieur du compteur 30 et en amont de celui-ci.

Un disjoncteur unique 35, en aval duquel se trouve l'installation électrique 41 qui n'est pas productrice de courant, est en outre monté à l'extérieur du compteur et en aval de celui-ci.

Un capteur de courant 36 et un deuxième organe de coupure 37 sont montés sur chaque conducteur de phase 31. Chaque capteur de courant 36 comporte ici un transformateur de courant 38 et non un shunt.

Une unité de traitement 39 est connectée aux trois conducteurs de phase 31 et au conducteur de neutre 33 en amont des capteurs de courant 36. De même, une unité d'alimentation 40 est connectée aux trois conducteurs de phase 31 et au conducteur de neutre 33 en amont des capteurs de courant 36. L'unité d'alimentation 40 est à nouveau associée à une batterie (ou à une supercapacité) qui permet d'alimenter les composants électriques lorsque les premiers organes de coupure 34 ou les deuxièmes organes de coupure 37 sont ouverts.

Ici, la tentative de by-pass frauduleux est réalisée à l'aide de trois fils 50 reliant chacun à l'extérieur du compteur 30 un point amont Pam du conducteur de phase 31 correspondant, le point Pam étant situé en amont du compteur 30 et en amont du premier organe de coupure 34 correspondant, à un point aval Pav du conducteur de phase 34 correspondant, le point Pav étant situé en aval du compteur 30.

L'unité d'alimentation 40 utilise les courants Ic circulant sur les conducteurs de phase 31 et provenant du réseau de distribution 42 pour alimenter les différents composants électriques du compteur 30 dont le fonctionnement requiert une énergie électrique.

Dans le compteur triphasé 30, le procédé de détection de l'invention consiste à mesurer trois courants de test Itest circulant dans les trois conducteurs de phase 31 grâce aux trois capteurs de courant 36 lorsque les trois premiers organes de coupure 34 sont ouverts et les trois deuxièmes organes de coupure 37 sont fermés.

La tentative de by-pass frauduleux est détectée en fonction des trois courants de test Itest mesurés.

L'envoi d'informations par courants porteurs en ligne est à nouveau assuré par l'unité de traitement 39 via l'un des fils 50 de by-pass.

Le procédé de détection de l'invention détecte une tentative de by-pass frauduleux lorsque le courant total égal à la somme des trois courants de test Itest (signés) présente un sens de circulation (ou un signe) correspondant à un sens d'aval en amont vers l'unité d'alimentation 40, et lorsque la valeur efficace du courant total est supérieure à un deuxième seuil de courant prédéterminé.

Dans un deuxième mode de réalisation, le procédé de détection de l'invention ne détecte pas une tentative de fraude directement à partir du courant de test Itest (pour le compteur monophasé 1) ou des trois courants de test Itest (pour le compteur triphasé 30), mais à partir de la puissance active et de la puissance réactive associées à ces courants de test Itest.

Ainsi, dans le cas d'un compteur monophasé, la tentative de by-pass frauduleux est détectée lorsque le courant de test circule d'aval en amont vers l'unité d'alimentation 14 et lorsque la puissance active et la puissance réactive associées au courant de test sont supérieures en valeur absolue à des premiers seuils de puissance prédéterminés.

Dans le cas d'un compteur triphasé, la tentative de by-pass frauduleux est détectée lorsqu'un courant total égal à la somme des trois courants de test Itest mesurés circule d'aval en amont vers l'unité d'alimentation 40 et lorsque la puissance active globale égale à la somme des puissances actives associées chacune à l'un des trois courants de test Itest et la puissance réactive globale égale à la somme des puissances réactives associées chacune à l'un des trois courants de test Itest sont supérieures en valeur absolue à des deuxièmes seuils de puissance prédéterminés.

Les puissances actives et réactives sont obtenues par intégration des puissances instantanées associées aux courants de test. Leur utilisation présente l'avantage de rendre la détection insensible aux bruits blancs sur les courants de test (et tensions associées).

L'invention n'est pas limitée aux modes de mise en oeuvre particuliers qui viennent d'être décrits, mais, bien au contraire, couvre toute variante entrant dans le cadre de l'invention telle que définie par les revendications.

Dans le cas du compteur triphasé, on peut aussi tenter de détecter un by-pass partiel, c'est-à-dire un by-pass réalisé par l'utilisateur fraudeur en court-circuitant un ou deux conducteurs de phase seulement en amont et en aval du compteur. On appliquera pour cela un critère de détection par phase, en tentant de détecter pour chaque phase un courant de test supérieur à un certain seuil ou des puissances active et réactive supérieures à certains seuils (comme dans le cas d'un compteur monophasé).

On note que, dans le cas où on utilise un critère de puissance, il n'est pas obligatoire de comparer à la fois la puissance active et la puissance réactive à des seuils prédéterminés : l'utilisation de l'une de ces deux puissances est suffisante.

Bien que l'on ait intégré un deuxième organe de coupure ou des deuxièmes organes de coupure à l'intérieur des compteurs présentés, le procédé de détection de l'invention peut parfaitement être mis en oeuvre sur des compteurs ne comportant pas de deuxième organe de coupure.

Pour mettre en oeuvre le procédé de détection de l'invention, il est parfaitement possible, à la place du capteur de courant décrit pour le compteur monophasé, d'utiliser un capteur de courant comprenant un transformateur de courant monté sur le conducteur de neutre du compteur. Il est aussi possible, à la place des capteurs de courant décrits pour le compteur triphasé, d'utiliser un capteur de courant comprenant un shunt monté sur le conducteur de neutre du compteur.

Le procédé de détection adapté au compteur triphasé peut bien sûr être mis en oeuvre sur tout compteur polyphasé.

## Revendications

1. Procédé de détection d'une tentative de by-pass frauduleux d'un compteur (1, 30) destiné à mesurer un courant circulant sur un conducteur (5, 31) entre un réseau de distribution (3, 42) situé en amont du compteur et une installation électrique (2, 41) située en aval du compteur, le compteur comprenant un capteur de courant (10, 36) monté sur le conducteur et une unité d'alimentation (14, 40) du compteur connectée au conducteur en amont du capteur de courant, un premier organe de coupure (8, 34) étant monté sur le conducteur en amont du compteur, où le procédé de détection comporte une étape de mesure au cours de laquelle on mesure un courant de test (Itest) grâce au capteur de courant lorsque le premier organe de coupure est ouvert et une étape de détection au cours de laquelle on détecte une tentative de by-pass frauduleux en fonction du courant de test (Itest) mesuré.

2. Procédé de détection selon la revendication 1, dans lequel la tentative de by-pass frauduleux est détectée lorsque le courant de test (Itest) circule d'aval en amont vers l'unité d'alimentation (14, 40) et sa valeur efficace est supérieure à un premier seuil de courant prédéterminé.

3. Procédé de détection selon la revendication 1, dans lequel la tentative de by-pass frauduleux est détectée lorsque le courant de test (Itest) circule d'aval en amont vers l'unité d'alimentation et lorsque la puissance active et/ou la puissance réactive associées au courant de test sont supérieures en valeur absolue à des premiers seuils de puissance prédéterminés.

4. Procédé de détection selon l'une des revendications précédentes, dans lequel le compteur comporte un deuxième organe de coupure (11, 37) monté sur le conducteur en aval du capteur de courant, le deuxième organe de coupure étant fermé au moment de l'étape de mesure.

5. Procédé de détection selon l'une des revendications précédentes, comportant en outre une étape consistant à augmenter la consommation électrique du compteur pour améliorer la détection en augmentant le courant de test en cas de tentative de fraude.

6. Procédé de détection selon les revendications 4 et 5, dans lequel l'augmentation de la consommation électrique du compteur est réalisée en effectuant une commande de fermeture du deuxième organe de coupure (11, 37) préalablement à l'étape de mesure.

7. Procédé de détection selon l'une des revendications précédentes, dans lequel le compteur communique le résultat de la détection par courants porteurs en ligne via une branche de dérivation (20, 50) utilisée pour réaliser la tentative de by-pass frauduleux.

8. Procédé de détection selon l'une des revendications précédentes, dans lequel le compteur est un compteur triphasé (30) destiné à mesurer trois courants circulant sur trois conducteurs (31) grâce à trois capteurs de courants montés chacun sur un conducteur, trois courants de tests (Itest) étant mesurés au cours de l'étape de mesure grâce aux trois capteurs de courant, la tentative de by-pass frauduleux étant détectée en fonction des trois courants de test mesurés.

9. Procédé de détection selon la revendication 8, dans lequel la tentative de by-pass frauduleux est détectée lorsqu'un courant total égal à la somme des trois courants de test mesurés circule d'aval en amont vers l'unité d'alimentation (40) et lorsque la valeur efficace du courant total est supérieure à un deuxième seuil de courant prédéterminé.

10. Procédé de détection selon la revendication 8, dans lequel la tentative de by-pass frauduleux est détectée lorsqu'un courant total égal à la somme des trois courants de test (Itest) mesurés circule d'aval en amont vers l'unité d'alimentation (40) et lorsque la puissance active globale égale à la somme des puissances actives associées chacune à l'un des trois courants de test et/ou la puissance réactive globale égale à la somme des puissances réactives associées chacune à l'un des trois courants de test sont supérieures à des deuxièmes seuils de puissance prédéterminés.

11. Compteur destiné à mesurer un courant circulant sur un conducteur (5, 31) entre un réseau de distribution (3, 42) situé en amont du compteur et une installation électrique (2, 41) située en aval du compteur, le compteur comprenant un capteur de courant (10, 36) monté sur le conducteur, une unité d'alimentation (14, 40) du compteur connectée au conducteur en amont du capteur de courant, et une unité de traitement (13), l'unité de traitement destinée à mettre oeuvre le procédé de détection selon l'une des revendications précédentes.

## Patentansprüche

1. Verfahren zur Erfassung eines betrügerischen Umgehungsversuchs an einem Zähler (1, 30), der dazu bestimmt ist, einen Strom zu messen, der auf einem Leiter (5, 31) zwischen einem Verteilernetz (3, 42), das sich flussaufwärts des Zählers befindet, und einer elektrischen Anlage fließt, die sich flussabwärts des Zählers befindet, wobei der Zähler einen Stromsensor (10, 36) umfasst, der an dem Leiter angebracht ist, sowie eine Versorgungseinheit (14, 40) zur Versorgung des Zählers, die an den Leiter flussaufwärts des Stromsensors angeschlossen ist, wobei ein erstes Unterbrechungsorgan (8, 34) an dem Leiter flussaufwärts des Zählers angebracht ist, wobei das Erfassungsverfahren einen Messschritt umfasst, während dessen ein Teststrom (Itest) mittels des Stromsensors gemessen wird, wenn das erste Unterbrechungsorgan offen ist, sowie einen Erfassungsschritt, während dessen ein betrügerischer Umgehungsversuch in Abhängigkeit von dem gemessenen Teststrom (Itest) erfasst wird.

2. Erfassungsverfahren nach Anspruch 1, bei dem der betrügerische Umgehungsversuch erfasst wird, wenn der Teststrom (Itest) flussaufwärts in Richtung der Versorgungseinheit (14, 40) fließt und sein Effektivwert größer als ein vorgegebener erster Stromschwellwert ist.

3. Erfassungsverfahren nach Anspruch 1, bei dem der betrügerische Umgehungsversuch erfasst wird, wenn der Teststrom (Itest) flussaufwärts in Richtung der Versorgungseinheit fließt und wenn die aktive Leistung und/oder die reaktive Leistung, die mit dem Teststrom verknüpft sind, im absoluten Wert größer als vorgegebene erste Leistungsschwellwerte sind.

4. Erfassungsverfahren nach einem der vorhergehenden Ansprüche, bei dem der Zähler ein zweites Unterbrechungsorgan (11, 37) umfasst, das an dem Leiter flussabwärts des Stromsensors angebracht ist, wobei das zweite Unterbrechungsorgan zum Zeitpunkt des Messschrittes geschlossen ist.

5. Erfassungsverfahren nach einem der vorhergehenden Ansprüche, ferner umfassend einen Schritt, der im Erhöhen des Stromverbrauchs des Zählers besteht, um die Erfassung zu verbessern, indem der Teststrom im Falle eines Betrugsversuchs erhöht wird.

6. Erfassungsverfahren nach den Ansprüchen 4 und 5, bei dem die Erhöhung des Stromverbrauchs des Zählers erfolgt, indem ein Schließbefehl zum Schließen des zweiten Unterbrechungsorgans (11, 37) vor dem Messschritt ausgeführt wird.

7. Erfassungsverfahren nach einem der vorhergehenden Ansprüche, bei dem der Zähler das Ergebnis der Erfassung mittels Trägerstrom-Kommunikation über eine Abzweigleitung (20, 50) übermittelt, die verwendet wird, um den betrügerischen Umgehungsversuch durchzuführen.

8. Erfassungsverfahren nach einem der vorhergehenden Ansprüche, bei dem der Zähler ein Dreiphasenzähler (30) ist, der dazu bestimmt ist, drei Ströme, die in drei Leitern (31) fließen, mittels dreier Stromsensoren zu messen, die jeweils an einem Leiter angebracht sind, wobei drei Testströme (Itest) während des Messschrittes mittels der drei Stromsensoren gemessen werden, wobei der betrügerische Umgehungsversuch in Abhängigkeit der drei gemessenen Testströme erfasst wird.

9. Erfassungsverfahren nach Anspruch 8, bei dem der betrügerische Umgehungsversuch erfasst wird, wenn ein Gesamtstrom, der gleich der Summe der drei gemessenen Testströme ist, flussaufwärts in Richtung der Versorgungseinheit (40) fließt und wenn der Effektivwert des Gesamtstroms größer als ein vorgegebener zweiter Stromschwellwert ist.

10. Erfassungsverfahren nach Anspruch 8, bei dem der betrügerische Umgehungsversuch erfasst wird, wenn ein Gesamtstrom, der gleich der Summe der gemessenen drei Testströme (Itest) ist, flussaufwärts in Richtung der Versorgungseinheit (40) fließt und wenn die gesamte aktive Leistung, die gleich der Summe der aktiven Leistungen ist, die jeweils mit einem der drei Testströme verknüpft sind, und/oder die gesamte reaktive Leistung, die gleich der Summe der reaktiven Leistungen ist, die jeweils mit einem der drei Testströme verknüpft sind, größer als vorgegebene zweite Leistungsschwellwerte sind.

11. Zähler, der dazu bestimmt ist, einen Strom zu messen, der auf einem Leiter (5, 31) zwischen einem Verteilernetz (3, 42), das sich flussaufwärts des Zählers befindet, und einer elektrischen Anlage (2, 41) fließt, die sich stromabwärts des Zählers befindet, wobei der Zähler einen Stromsensor (10, 36) umfasst, der auf dem Leiter angebracht ist, eine Versorgungseinheit (10, 36) zur Versorgung des Zählers, die an den Leiter stromaufwärts des Stromsensors angeschlossen ist, sowie eine Verarbeitungseinheit (13), wobei die Verarbeitungseinheit dazu bestimmt ist, das Erfassungsverfahren nach einem der vorhergehenden Ansprüche durchzuführen.

## Claims

1. A method of detecting an attempt at fraudulently bypassing a meter (1, 30) for measuring a current flowing along a conductor (5, 31) between a distribution network (3, 42) situated upstream from the meter and an electrical installation (2, 41) situated downstream from the meter, the meter comprising a current sensor (10, 36) mounted on the conductor and a power supply unit (14, 40) for the meter connected to the conductor upstream from the current sensor, a first cutoff member (8, 34) being mounted on the conductor upstream from the meter, wherein the detection method comprises a measurement step during which a test current (Itest) is measured by the current sensor while the first cutoff member is open, and a detection step during which an attempt at fraudulent bypass is detected as a function of the test current (Itest) as measured.

2. A detection method according to claim 1, wherein a fraudulent bypass attempt is detected when the test current (Itest) flows from downstream to upstream towards the power supply unit (14, 40) and its rms value is greater than a first predetermined current threshold.

3. A detection method according to claim 1, wherein a fraudulent bypass attempt is detected when the test current (Itest) flows from downstream to upstream towards the power supply unit and when the active power and/or the reactive power associated with the test current are greater in absolute value than first predetermined power thresholds.

4. A detection method according to any preceding claim, wherein the meter includes a second cutoff member (11, 37) mounted on the conductor downstream from the current sensor, the second cutoff member being closed at the time of the measurement step.

5. A detection method according to any preceding claim, further comprising a step consisting in increasing the electricity consumption of the meter in order to improve detection by increasing the test current in the event of attempted fraud.

6. A detection method according to claims 4 and 5, wherein the electrical consumption of the meter is increased by issuing an order to close the second cutoff member (11, 37) prior to the measurement step.

7. A detection method according to any preceding claim, wherein the meter communicates the result of the detection by powerline carrier via a branch connection (20, 50) used for performing the fraudulent bypass attempt.

8. A detection method according to any preceding claim, wherein the meter is a three-phase meter (30) for measuring three currents flowing in three conductors (31) by means of three current sensors each mounted on a respective conductor, three test currents (Itest) being measured during the measurement step by using the three current sensors, with a fraudulent bypass attempt being detected as a function of the three test currents as measured.

9. A detection method according to claim 8, wherein a fraudulent bypass attempt is detected when a total current equal to the sum of the three measured test currents flows from downstream to upstream towards the power supply unit (40) and when the rms value of the total current is greater than a second predetermined current threshold.

10. A detection method according to claim 8, wherein a fraudulent bypass attempt is detected when a total current equal to the sum of the three measured test currents (Itest) flows from downstream to upstream towards the power supply unit (40) and when the overall active power equal to the sum of the active powers associated with each of the three test currents and/or the overall reactive power equal to the sum of the reactive powers associated with each of the three test currents are greater than second predetermined power thresholds.

11. A meter for measuring a current flowing in a conductor (5, 31) between a distribution network (3, 42) situated upstream from the meter and an electrical installation (2, 41) situated downstream from the meter, the meter comprising a current sensor (10, 36) mounted on the conductor, a power supply unit (14, 40) for the meter connected to the conductor upstream from the current sensor, and a processor unit (13), the processor unit being suitable for performing the detection method according to any preceding claim.
